Europäisches Patentamt

European Patent Office

Office européen des brevets

(19)

(11) **EP 1 400 608 A1**

(12) **EUROPEAN PATENT APPLICATION**
published in accordance with Art. 158(3) EPC

(43) Date of publication:
24.03.2004 Bulletin 2004/13

(51) Int Cl.⁷: **C23C 14/34**, C23C 14/46,
G02B 5/08, G02B 5/28

(21) Application number: 02700781.4

(22) Date of filing: 26.02.2002

(86) International application number:
PCT/JP2002/001713

(87) International publication number:
WO 2002/077316 (03.10.2002 Gazette 2002/40)

(84) Designated Contracting States:
AT BE CH CY DE DK ES FI FR GB GR IE IT LI LU
MC NL PT SE TR
Designated Extension States:
AL LT LV MK RO SI

(30) Priority: 22.03.2001 JP 2001083094
22.03.2001 JP 2001083095

(71) Applicant: **Nikon Corporation**
**Tokyo 100-8331 (JP)**

(72) Inventor: **KANDAKA, Noriaki**
**Chiyoda-ku, Tokyo 100-8331 (JP)**

(74) Representative: **Viering, Jentschura & Partner**
**Steinsdorfstrasse 6**
**80538 München (DE)**

(54) **FILM FORMING METHOD, MULTILAYER FILM REFLECTOR MANUFACTURING METHOD, AND FILM FORMING DEVICE**

(57)     A film forming method and apparatus are provided, in which, as shown in Fig.4, a rotational symmetrical substrate 41 on which a film is formed is rotated along the rotational symmetry axis in a sufficiently vacuum container 40. And, a target material 42 in the container 40 is heated or irradiated ion beam to scatter atoms of the target material 42 and deposited the scattered atoms on the substrate 41. A film thickness regulating plate 10 which shields part of the scattered atoms is arranged near the substrate 41. The film thickness regulating plate 10 is composed a shape-constant regulating plate 11 as shown in Fig.3 and a shape-variable regulating plate 21 as shown in Fig.2.

*FIG. 1*

## Description

TECHNICAL FIELD

The present invention relates to a film forming apparatus for forming a film on a surface of a substrate, a film forming method, and a manufacturing method of a multi-layered reflection mirror.

BACKGROUND ART

Recently, a manufacturing method of semiconductor integrated circuits, in which a very fine pattern formed on a mask is demagnified and projected by visible light or ultraviolet light and the pattern is transferred on a silicon wafer coated with a resist, have been widely employed. However, as the pattern has become smaller in size, the resolution of the demagnification projection exposure method utilizing ultraviolet light reaches to the diffraction limit. Then, a demagnification projection exposure method utilizing extreme ultraviolet light( EUV) with a wavelength of 13 nm or 11 nm which is shorter than ultraviolet light, is proposed.

Since light in the EUV band is strongly absorbed in almost materials so that refraction type optical elements such as lenses cannot be employed, an optical system for the demagnification projection is constructed from reflection mirrors. On a surface of the reflection mirror, a coating having a multi-layered film structure is provided in order to raise the reflectivity. It is found that the reflectivity at a wavelength of about 13 nm enables to be 60% or more when a Mo/Si multi-layered film is employed. In the EUV lithography technique, it is thought that by constituting an optical system from the multi-layered film reflection mirrors, a demagnification projection exposure apparatus capable of forming a pattern with 0.1 μm or less and having a high capacity ( through-put) can be realized.

When such optical system is manufactured, it is very important to control a periodic length of the multi-layered film coated on the surface of the reflection mirror. A wavelength at which a multi-layered film exhibits a high reflectivity is dependent on a periodic length of the multi-layered film and an angle of incidence of incident EUV light. Therefore, the multi-layered film must have a periodic length at which a high reflectivity can be obtained for EUV light with a wavelength used in the exposure. And, since an angle of incidence of EUV light at each point on each of the reflection mirrors constructing the optical system is not constant even on one reflection mirror, the multi-layered film has to be formed while controlling a periodic length distribution of the multi-layered film on the reflection mirror correspondent to an angle of incidence. And, when a multi-layered film is formed by using a vacuum evaporation method or a sputtering method, which are conventional methods for forming a film on a substrate, an undesirable periodic length distribution may occur in the multi-layered film on the substrate. Thus, on the film forming, the periodic length distribution of the multi-layered film must be controlled by some means.

The optical system used for the demagnification projection exposure apparatus is so constructed that an arc part( about 1~2 mm to the radius direction, about 25 mm to the circumference direction) of a mask on which a pattern to be exposed is drawn is demagnified and projected on a wafer. And, a EUV light reflection surface of each of the multi-layered film reflection mirrors is concave or convex shaped and rotational symmetry. On such structure, an angle of incidence of EUV light incident on each multi-layered film reflection mirror is constant to the circumference direction and varies to the radius direction. Therefore, a periodic length distribution of the multi-layered film for the reflection mirror is required to be rotational symmetry.

An example of a method for forming a film while controlling the film thickness will be explained referring to drawings. This film forming method is applied to a method for forming a film while controlling a periodic length of the multi-layered film.

Fig.7 is a plane drawing showing a principle part of a conventional film forming apparatus.

Fig.8 is a plane drawing showing a shape of a conventional film thickness regulating plate.

Fig.9 is a graph showing a change in a film thickness distribution depending on existence or nonexistence of the film thickness regulating plate.

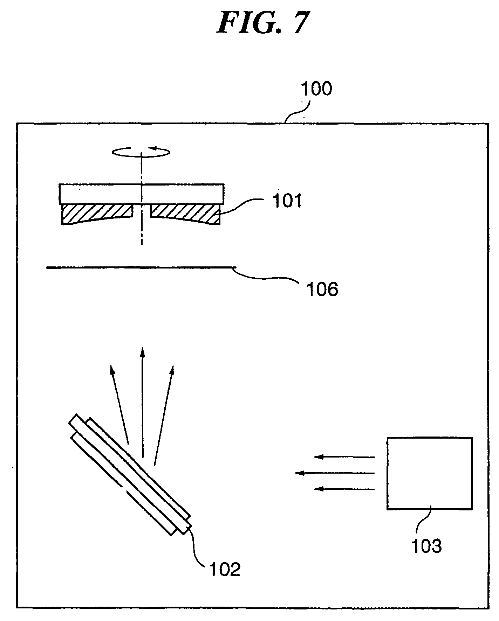

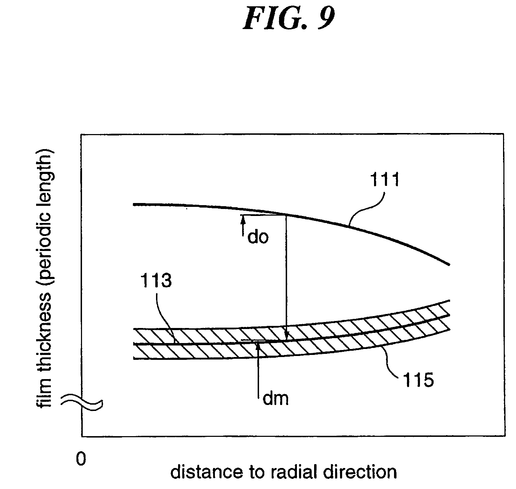

Firstly, an overview of the film forming process will be explained referring to Fig.7. A substrate 101 on which a film is formed is, for instance, a rotational symmetrical and concave substrate( for instance, secondary mirror of Schwaltzschild mirror) having an opening at the center thereof. The film forming is carried out in a vacuum container 100 by irradiating a target material 102 to become a film material with an ion beam from an ion source 103 to scatter atoms of the target material, and depositing the scattered atoms of the target material 102 on a surface of a substrate 101 which is arranged in the container 100. During the film forming, the substrate 101 is rotated along the axis of symmetry so that a film having a same film thickness to the circumference direction is formed. However, the film thickness is not constant to the radius direction thereby resulting in a film thickness distribution, as shown in a curve 111 in Fig.9 for instance.

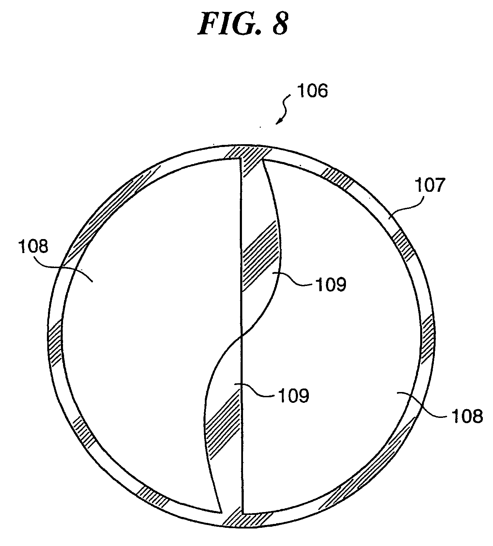

Next, a film forming method while controlling the curve 111 showing the distribution of the film thickness in a target range 115 will be explained. To control the curve 111, a film thickness regulating plate 106 is arranged near the substrate 101 at the film forming. The film thickness regulating plate 106 is composed of a supporting plate 107 having an opening 108 as shown in Fig.8. In the opening 108, a shielding plate 109 having a specified profile to the radius direction is provided. The film thickness regulating plate 106 has a shape controlled in the opening rate to the radius direction. Here, the opening rate p(r) is expressed in the following equation.

$$p(r)= (dm(r))/(do(r))$$

(do(r): a film thickness on the substrate without the regulating plate, dm(r): a desirable film thickness on the substrate, r: a distance from the center of the substrate)

By using the film thickness regulating plate 106, the film thickness is relatively controlled to the radius direction, so a film thickness distribution, shown in curve 113, in the target range 115 in Fig.9 can be achieved.

In order to obtain a desirable film thickness ( periodic length) distribution by using the film thickness regulating plate 106 as shown in Fig.8, the film thickness regulating plate is required a high shape precision. For instance, when the opening rate of 80 % at a portion 5 cm away from the center, and the precision of under ± 0.01 nm for the periodic length of 6.9 nm is required in order to control the periodic length( film thickness) of the multi-layered film, a shape precision of at least ± 0.18 mm to the circumference direction of the film thickness regulating plate is required. A further high precision is required for a part closer to the rotational center.

The shape of the film thickness regulating plate is determined by predicting its optimum shape based on a distribution of the sputtering particles( scattered atoms) discharged from the target material and the film thickness distribution that should be obtained on the substrate. However, if the film forming is carried out using the film thickness regulating plate having the shape obtained by such manner, it is difficult to obtain a desirable film thickness distribution, because the accurate prediction of the distribution of the spauttering particles discharged from the target material is so difficult that the prediction at the beginning is not accurate. Therefore, a film forming is carried out in practical by using a film thickness regulating plate having a certain shape, the resultant film thickness distribution is evaluated, and the film thickness regulating plate should be re-made several times while correcting and changing the shape based on the evaluations.

And, even if the shape of the film thickness regulating plate having a desirable film thickness distribution can be obtained, it does not mean that such desirable film thickness distribution can be obtained permanently by using the film thickness regulating plate, because the characteristics of the film forming apparatus are slightly varied. When the variation in the film thickness distribution due to the variation in the characteristics of the apparatus goes beyond an allowable range, the shape of the film thickness regulating plate must be changed. In such case, the film thickness must be controlled in the above-mentioned procedure. At the time, since the film thickness regulating plate must be manufactured in the precision of at least 0.1 mm for the above-mentioned request, the manufacturing takes certain length of time. So, there is a problem that the time for a film forming with a desirable film thickness distribution and a manufacturing of a multi-layered film reflection mirror having a desirable periodic length is lengthened.

Next, another background art will be explained.

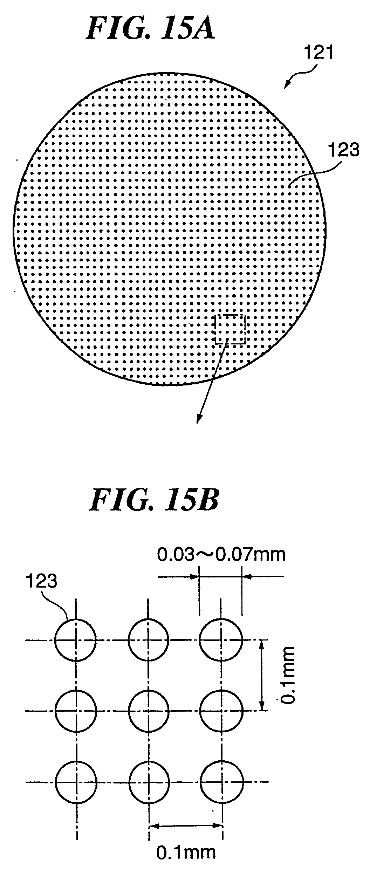

As another method for forming a film on a substrate while controlling the film thickness, a method( W. C.Sweatt et, al. OSATOPS on Extreme Ultraviolet Lithography, 149(1996) Vol.4, Glenn D. Kubiak and Don Kaia eds.) using a film thickness regulating plate having different shape from that of the above-mentioned method is also proposed. The proposal is referred to the method for forming a film with a controlled film thickness on the substrate machined in a spherical surface to obtain an aspheric surface with a high precision. This method will be explained referring to Fig. 15 to 17.

Fig. 15 is a plane drawing showing another embodiment of a conventional film thickness regulating plate, Fig.15(A) is a drawing showing a whole shape, Fig.15(B) is a drawing enlarged showing an opening.

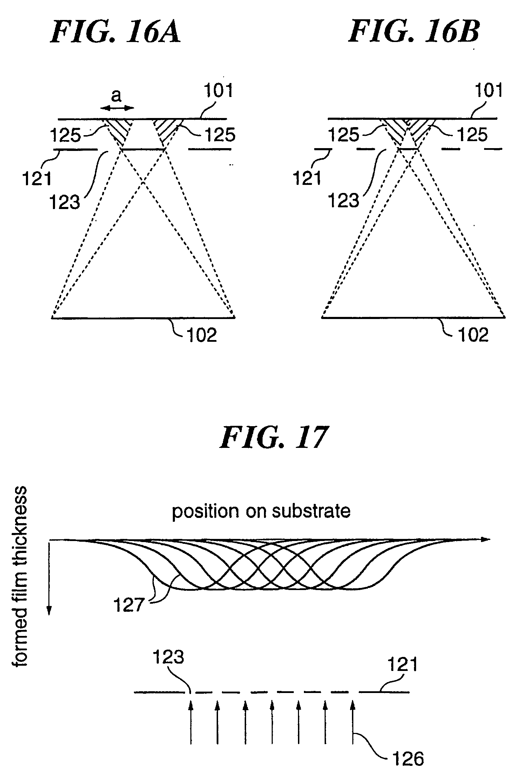

Fig.16 is a schematic drawing showing a half shadow of the film thickness regulating plate on the substrate.

Fig.17 is a schematic drawing explaining the uniformity of the film thickness on the substrate.

A film thickness regulating plate 121 as shown in Fig. 15 is disk shaped, and fine openings 123 are formed all over surf ace. Each opening 123, as enlarged shown in Fig.15(B), is circle shaped with a diameter of 0.03 to 0.07 mm, and a distance between the centers of openings 123 is 0.1 mm. The diameter of the opening is large in a portion correspondent to a region on which the film is more thickly formed, while the diameter of the opening is small in a portion correspondent to a region on which the film is more thinly formed.

By the way, as shown in Fig.16(A), since the region where a particle is discharged from the target material 102 has a finite size, what is called, a half shadow 125 appears on the substrate 101 by the film thickness regulating plate 121. The area " a " of the half shadow 125 is varied by a size of the target material 102, and a positional relationship between the target material 102 and the film thickness regulating plate 121 and the substrate 101, etc.. And, the way of appearance of the half shadow on the substrate is varied by a distance between the openings 123 of the film thickness regulating plate 121. For instance, as shown in Fig.16(B), when a distance between the openings 123 is smaller relative to the area of the half shadow, each of the half shadows 125 overlaps each other.

On the film forming, generally, the distance between the openings 123 of the film thickness regulating plate 121 is made smaller relative to the area of the half shadow appeared on the substrate. Thus, as shown in Fig.17, a film thickness distributions 127 caused by the scattered particles 126 passed through each opening 123 of the film thickness regulating plate 121 are overlapped each other so that the uniformity of the film thickness due to the appearance of the half shadow caused by the film thickness regulating plate does never become a problem. Accordingly, when the film thickness regulating plate 121 is made to have a distribution of the opening rate in the radius direction on the basis of the size of a opening 123 of the film thickness regulating plate 121 and the number density of the opening 123, a smoothly film thickness distribution can be obtained on the substrate.

On considering the area of the half shadow, it is not easy to control the film thickness near the axis of symmetry of the rotational symmetrical substrate ( center of the substrate) by using the film thickness regulating plate 106 having a shielding plate with a certain profile as shown in Fig.8. Since, as mentioned above, the region where the particle is scattered from the target material has a finite size, the film thickness regulating plate makes the half shadow to appear on the substrate on which a film is formed. The half shadow considerably influences on the center of the substrate, where the rate of a portion caused the appearance of the half shadow to the all circumference is large, so that it is difficult to predict the influence correctly. In order to control the thickness of the film to be formed on considering such influence, it is necessary that the position and the distribution of the angle in which the sputtering particles are discharged from the target material are obtained accurately. However, since it is difficult to measure the distribution of the sputtering particles on all over the surface of the target material in practical, the film thickness can not be controlled on the center of the substrate in some cases.

However, in the EUV lithography technique, it is desirable to use the center of the multi-layered reflection mirror also, so that a film must be formed while being controlled the film thickness on the center of the substrate.

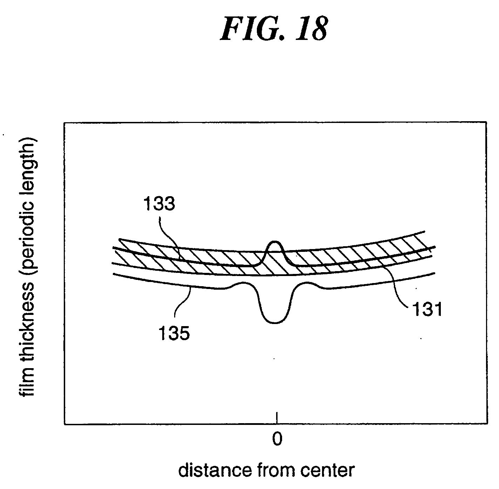

Fig.18 is a graph showing an example where the film thickness is imperfectly controlled. The ordinate axis shows a film thickness on the substrate, and the abscissa axis shows a distance from the center of the substrate.

In the case that the film thickness can not be controlled in the center of the substrate, there is a high danger for the film thickness distribution on the substrate that the film thickness is thick in the center of the substrate as shown by the curve 133, or the film thickness is thin all over the substrate while the film thickness is locally thick in the center of the substrate as shown in the curve 135. Generally, the periodic length distribution of the multi-layered film required to the multi-layered film reflection mirror for the EUV lithography, for instance, is within the range 131 as shown in oblique line, and relatively uniform in the center of the substrate. However, it is not easy to control the film thickness by using the film thickness regulating plate 106 as shown in Fig.8. And, while such film thickness regulating plate is made of a thin plate, when the thickness thereof is too thin, there is a problem that the film thickness regulating plate may be deformed due to the stress of the formed film.

On the other hand, in the case of the porous film thickness regulating plate 121 as shown in Fig.15, the film thickness can be controlled all over area of the substrate including the center thereof. However, the structure of such film thickness regulating plate is complicated so that the manufacturing thereof requires longer time and higher cost than that of the regulating plate as shown in Fig.8. And, although a distance between the openings must make thin in order to heighten the opening rate, it is not easy to heighten the opening rate from the view of the structure strength. For instance, the film thickness regulating plate, as shown in Fig.15, has an opening rate of about 38% when the openings with the diameter of 0.07mm are arranged with a distance of 0.1mm. When the opening rate is low, a long film forming time is required in order to obtain the desirable film thickness. Accordingly, there is a problem that time for forming a film having a desirable film thickness and manufacturing a multi-layered film reflection mirror having a desirable periodic length distribution is lengthened.

The present invention has been made to solve the above-described problems, and has an object to provide a film forming method and a film forming apparatus for obtaining a desirable film thickness in shorter time. And, another object is to provide a method for manufacturing a multi-layered film reflection mirror having a desirable film thickness in shorter time.

## DISCLORSURE OF THE INVENTION

In order to solve the above-mentioned problems, a film forming method according to a first aspect of the present invention comprises: rotating a rotational symmetrical substrate on which a film is formed along the rotational symmetry axis in a sufficiently vacuum container; heating or irradiating ion beam to a target material in the container to scatter atoms of the target material; and depositing the scattered atoms on the substrate, wherein a film thickness regulating plate which shields part of the scattered atoms is arranged near the substrate, said regulating plate being variable in shape.

A film forming apparatus according to a first aspect of the present invention, which rotates a rotational symmetrical substrate on which a film is formed along the rotational symmetry axis in a sufficiently vacuum container; heats or irradiates ion beam a target material in the container to scatter an atom of the target material; and deposits the scattered atoms on the substrate, wherein a film thickness regulating plate which shields part of the scattered atoms is arranged near the substrate, said regulating plate being variable in shape.

A film forming apparatus according to a first embodiment of the present invention comprises: a container capable of being vacuumed; means for rotating a substrate on which a film is formed, arranged in said container; a holder for supporting a target material, arranged in the container; means for scattering atoms of the target material; and a film thickness regulating plate which shields part of the scattered atoms arranged between the substrate rotating means and the target material holder, wherein said film thickness regulating plate is variable in shape.

According to the present invention, the shape of the film thickness plate can be freely varied in shorter time. So, the time required to make the regulating plate among the time required to obtain a desirable film thickness distribution is reduced thereby to readily have a film with a desirable film thickness distribution.

Also, it is preferable for the film forming apparatus according to the present invention that the film thickness regulating plate is composed of a shape-constant regulating plate and a shape-variable regulating plate. And, it is preferable that the shape-variable regulating plate is provided with shielding elements and drivers, and the driver moves the shielding element with a position precision of at least 0.01 mm.

According to the present invention, the whole shape of the film thickness regulating plate can be varied with a precision of at least 0.1 mm thereby to obtain the regulating plate having a desirable shape readily and accurately. As the result, a desirable periodic length distribution required to the multi-layered film can be obtained readily.

A manufacturing method for a multi-layered film reflection mirror according to the present invention is a method, wherein a multi-layered structure that at least two types of substance having a different reflective index are deposited alternatively is formed on a substrate by means of the above-mentioned film forming method.

According to the present invention, the shape of the film thickness regulating plate can be freely varied in shorter time. So, the time required to make the regulating plate among the time required to obtain a desirable film thickness distribution is reduced thereby to readily have a multi-layered film reflection mirror with a desirable periodic length distribution.

A film forming method according to a second aspect of the present invention comprises: rotating a rotational symmetrical substrate on which a film is formed along the rotational symmetry axis in a sufficiently vacuum container; heating or irradiating ion beam to a target material in the container to scatter atoms of the target material; and depositing the scattered atoms on the substrate, wherein a film thickness regulating plate which shields part of the scattered atoms is arranged near the substrate, said film thickness regulating plate having a plurality of openings arranged scatteringly with a distance under half of an area of a half shadow of said film thickness regulating plate, appeared on the substrate by a particle beam made of the scattered atoms of the target material, near the part correspondent to the rotational axis of symmetry of the substrate; and an opening of which the opening rate is controlled by relatively small number of shielding plates arranged partially in the radial direction, near the part correspondent to the periphery of the substrate.

A film forming apparatus according to a second aspect of the present invention, which rotates a rotational symmetrical substrate on which a film is formed along the rotational symmetry axis in a sufficiently vacuum container; heats or irradiates ion beam to a target material in the container to scatter an atom of the target material; and deposits the scattered atoms on the substrate, wherein a film thickness regulating plate which shields part of the scattered atoms is arranged near the substrate, said film thickness regulating plate having a plurality of openings arranged scatteringly with a distance under half of an area of a half shadow of said film thickness regulating plate, the half shadow appeared on the substrate by a particle beam made of the scattered atoms of the target material, near the part correspondent to the rotational symmetrical axis of the substrate; and an opening of which the opening rate is controlled by relatively small number of shielding plates arranged partially in the radial direction, near the part correspondent to the periphery of the substrate.

A film forming apparatus according to a second embodiment of the present invention comprises: a container capable of being vacuumed, means for rotating a substrate on which a film is formed, arranged in said container, a holder for supporting a target material, arranged in the container, means for scattering atoms of the target material; and a film thickness regulating plate which shields part of scattered atoms arranged between the substrate rotating means and the target material holder, wherein said film thickness regulating plate has a plurality of openings arranged scatteringly with a distance under half of an area of a half shadow of said film thickness regulating plate, the half shadow appeared on the substrate by a particle beam made of the scattered atoms of the target material; near the part correspondent to the rotational axis of symmetry of the substrate; and an opening of which the opening rate is controlled by relatively small number of shielding plates arranged partially in the radial direction, near the part correspondent to the periphery of the substrate.

According to the present invention, since the openings are scatteringly arranged in the center of the substrate, the film thickness distribution can be easily controlled at the center of the substrate. And, the film thickness regulating plate has a relatively simple structure at the peripheral part thereof and can vary the opening rate freely so that a desirable film thickness distribution can be obtained at also the peripheral part of the substrate in shorter time.

Also, it is preferable for the film forming apparatus according to the present invention that the openings are so arranged that the opening rate thereof is uniform to the radial direction of the film thickness regulating plate. In such case, at the center of the substrate, a film forming is carried out without intentionally regulating the film thickness distribution. Generally, in the case for forming a film while rotating a substrate, when the film thickness is not regulated( the opening rate distribution of the film thickness regulating plate is equal), the film thickness distribution becomes uniform at the center of the substrate. The film thickness distribution required to the multi-layered film reflection mirror for the practical EUV lithography is uniform at the center, so that it is preferable that the film thickness is uniform at the center of the substrate as mentioned above. Then, when the openings are scatteringly arranged at the center of the film thickness regulating plate so that the opening rate thereof is uniform to the radial direction of the film thickness regulating plate, it is possible to uniformly lower the thickness of the film formed on the center of the substrate.

Also, it is preferable that the openings are so arranged that the opening rate thereof is intentionally controlled to the radial direction of the film thickness regulating plate. Even when the above-mentioned regulating of the film thickness distribution is not carried out and the relative film thickness distribution produced near the axis( center) of symmetry of the substrate does not become desirable, the opening rate of the regulating plate on which the openings are scatteringly arranged is varied in response of the distance from the axis of symmetry to be able to achieve a desirable film thickness distribution. In this case, even if a desirable film thickness distribution is not uniform at the center of the substrate, the film having such distribution can be formed.

According to the present invention, it is preferable that the film thickness regulating plate is composed of a center regulating plate having scatteringly arranged openings, arranged near the part correspondent to the rotational axis of symmetry of the substrate, and a peripheral regulating plate having an opening controlled the opening rate to the radial direction, arranged in the periphery of the substrate. By separating the center regulating plate from the peripheral regulating plate, each of the plates enables to have a relatively simple structure. Therefore, it is easy to prepare the film thickness regulating plate.

According to the present invention, it is preferable that the thickness of the film thickness regulating plate is over 0.5 mm. Or, it is also preferable that the film thickness regulating plate is supported by a supporting frame having a thickness of over 0.5 mm. In these cases, even if depositing atoms shielded by the non-opening portion, the film thickness regulating plate is not easily deformed due to the stress of the deposited film so that a suitable film thickness distribution can be obtained stably.

Also, it is preferable that the film thickness regulating plate has a structure capable of being positioned to the substrate with a precision of under 0.1 mm. In this case, the film thickness regulating plate can be correctly positioned relative to the substrate to form a film with an optimum film thickness distribution. If the film thickness regulating plate is shifted relative to the substrate, the center( the rotational axis of symmetry) of the opening rate distribution of the regulating plate is displaced from the center whereby a film forming with an optimum film thickness distribution becomes difficult. Then, by using the film thickness regulating plate having a structure capable of being positioned accurately, the film thickness regulating plate can be arranged even if mounted again after removing it.

A manufacturing method for a multi-layered film reflection mirror according to another aspect of the present invention, in which a multi-layered film having a structure that at least two types of substance having a different reflective index are deposited alternatively is formed on a substrate by above-mentioned film forming method.

According to the present invention, the film thickness distribution can be easily controlled at the center of the substrate and a desirable film thickness distribution is obtainable in shorter time. Therefore, a multi-layered film reflection mirror having a desirable periodic length distribution can be obtained readily.

BRIEF DESCRIPTION OF THE DRAWINGS

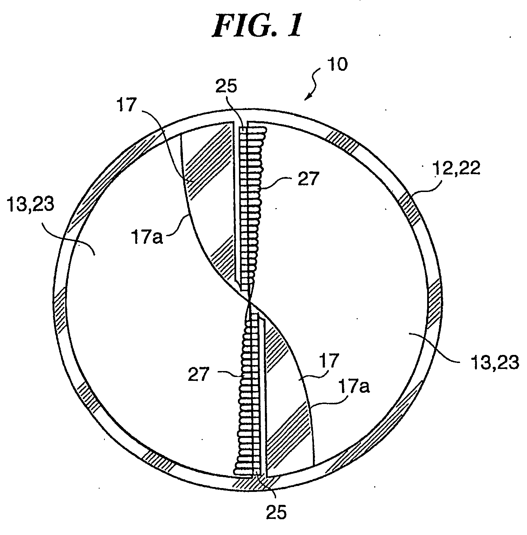

Fig.1 is a plane drawing showing a shape of a film thickness regulating plate used in a film forming apparatus according to the first embodiment of the present invention.

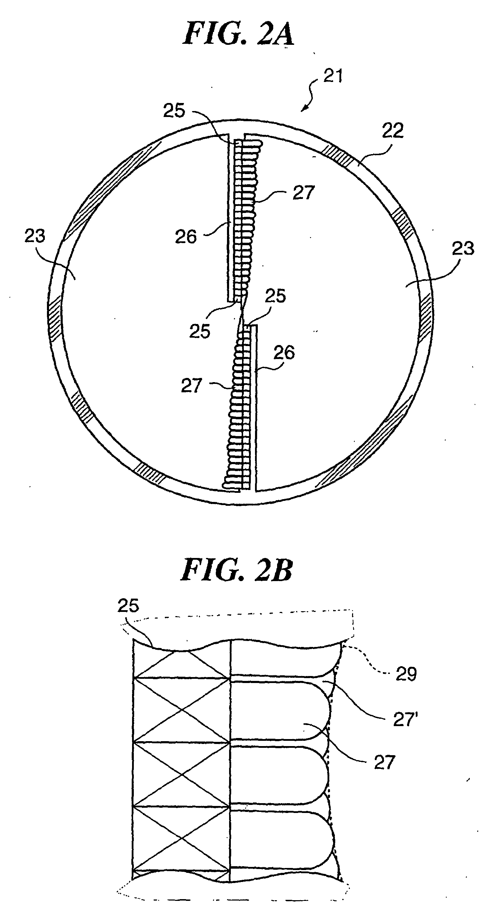

Fig.2(A) is a plane drawing showing a shape of a shape-variable regulating plate which is a part of the film thickness regulating plate as shown in Fig.1, Fig.2(B) is a plane drawing enlarged showing a part of the shape-variable regulating plate.

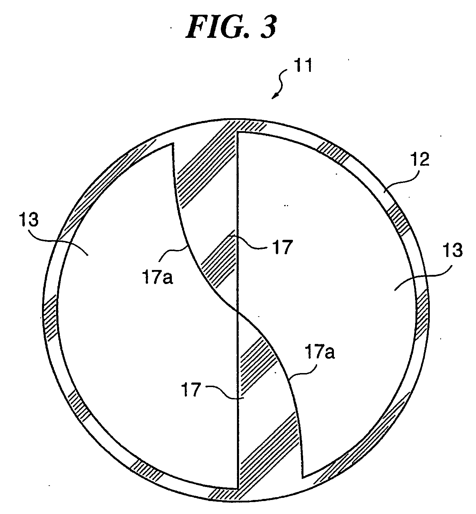

Fig.3 is a plane drawing showing a shape of a shape-constant regulating plate which is a part of the film thickness regulating plate as shown in Fig.1.

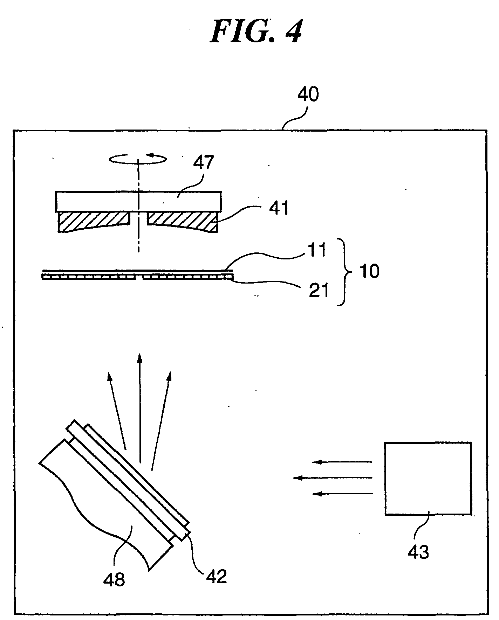

Fig.4 is a drawing schematically showing a principle part of a film forming apparatus according to the first embodiment of the present invention.

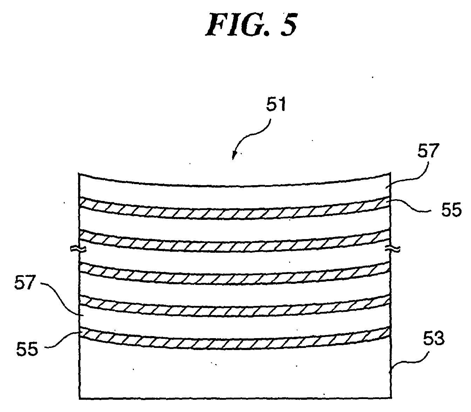

Fig.5 is a cross sectional view schematically showing a Mo/Si multi-layered film reflection mirror manufactured by a manufacturing method according to the present invention.

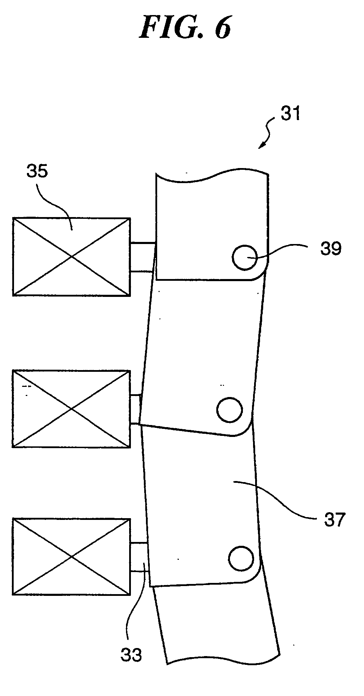

Fig.6 is a plane drawing showing a shape-variable film thickness regulating plate which is a part of the film thickness regulating plate used to a film forming apparatus according to another embodiment of the present invention.

Fig.7 is a plane drawing showing a principle part of a conventional film forming apparatus.

Fig.8 is a plane drawing showing a shape of a conventional film thickness regulating plate.

Fig.9 is a graph showing a change in a film thickness distribution depending on the film thickness regulating plate.

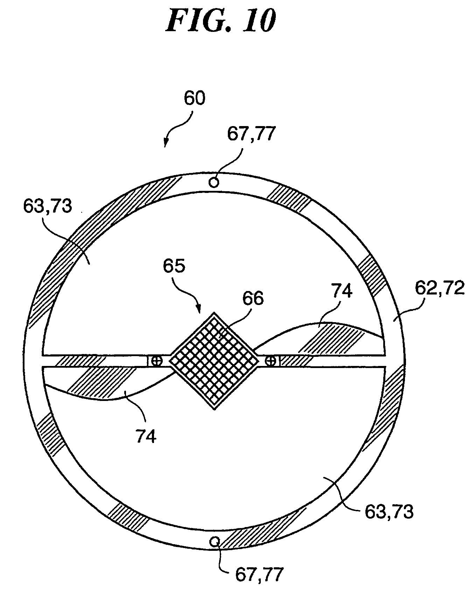

Fig. 10 is a plane drawing showing a shape of the film' thickness regulating plate used to a film forming apparatus according to the second embodiment of the present invention.

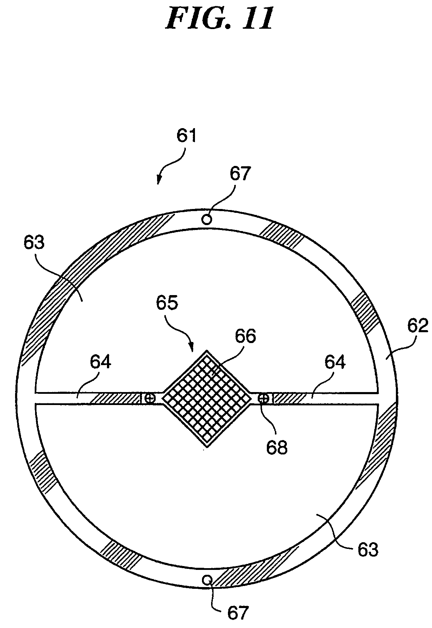

Fig.11 is a plane drawing showing a shape of a center regulating plate which is a part of the film thickness regulating plate of Fig.10.

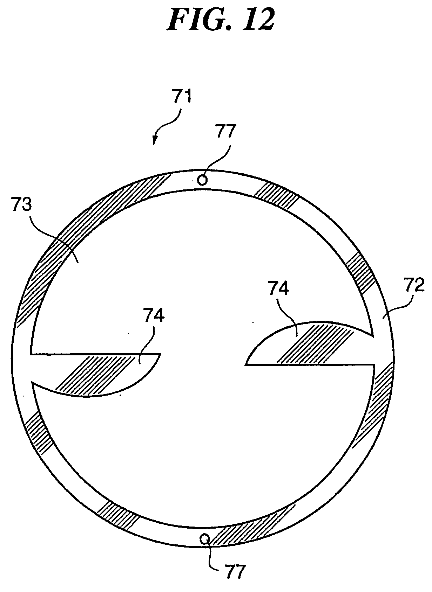

Fig.12 is a plane drawing showing a shape of a peripheral regulating plate which is a part of the film thickness regulating plate of Fig.10.

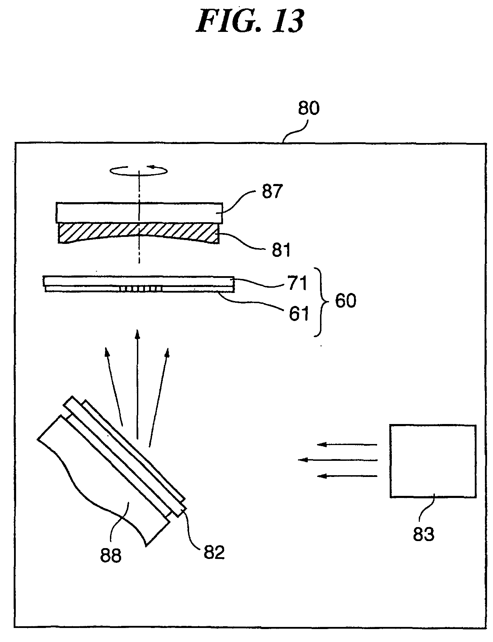

Fig.13 is a drawing schematically showing a principle part of a film forming apparatus according to the second embodiment of the present invention.

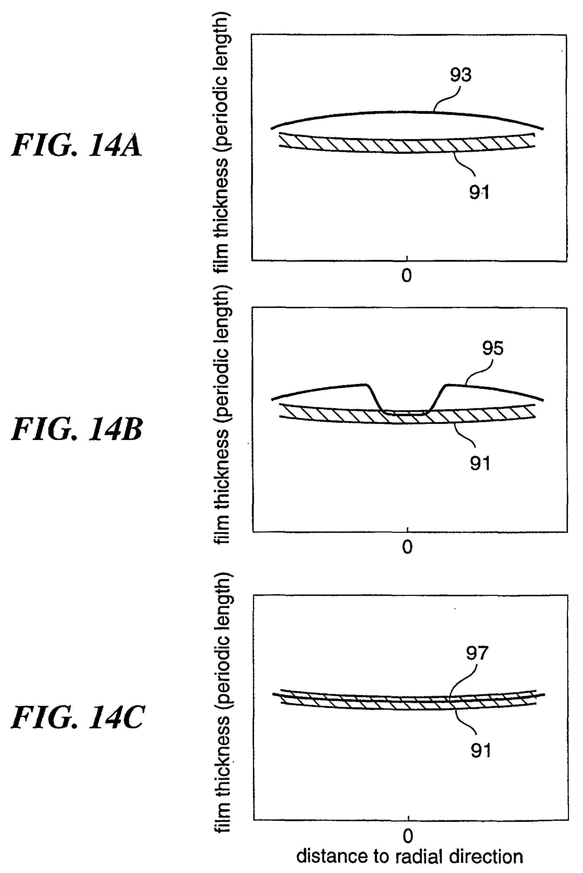

Fig.14 is a graph showing a variation in a film thickness distribution due to a film forming method according to the present invention.

Fig. 15 is a plane drawing showing another embodiment of a conventional film thickness regulating plate, Fig.15(A) is a drawing showing a whole shape, Fig.15(B) is a drawing enlarged showing an opening.

Fig.16 is a schematic drawing showing a half shadow of the film thickness regulating plate on the substrate.

Fig.17 is a schematic drawing explaining the uniformity of the film thickness on the substrate.

Fig.18 is a graph showing an example where the film thickness is imperfectly controlled.

## DESCRIPTION FOR CARRYING-OUT OF THE INVENTION

The embodiment of a forming method of a multi-layered film used in EUV reflection mirror will be described in detail with reference to drawings.

Fig.1 is a plane drawing showing a shape of a film thickness regulating plate used in a film forming apparatus according to the first embodiment of the present invention.

Fig.2(A) is a plane drawing showing a shape of a shape-variable regulating plate which is a part of the film thickness regulating plate as shown in Fig.1, Fig.2(B) is a plane drawing enlarged showing a part of the shape-variable regulating plate.

Fig.3 is a plane drawing showing a shape of a shape-constant regulating plate which is a part of the film thickness regulating plate as shown in Fig.1.

Fig.4 is a drawing schematically showing a principle part of a film forming apparatus according to the first embodiment of the present invention.

Fig.5 is a cross sectional view schematically showing a Mo/Si multi-layered film reflection mirror manufactured by a manufacturing according to the present invention.

Firstly, a case that a Mo/Si multi-layered film is formed on a substrate with a desirable periodic length ( film thickness) distribution will be described referring to Fig. 4 and Fig.5. A multi-layered film reflection mirror 51 as shown in Fig.5 has a structure in which a Mo-layer 55 and a Si-layer 57 are deposited alternately on an upper surface of a substrate 53, and reflects X-rays of a wavelength of 13 nm. The multi-layered film composing of the Mo-layer 55 and the Si-layer 57 is formed by 50 layer-pair( 1 layer-pair means one pair comprising one Mo-layer 55 and one Si-layer 57), for instance, with the most upper layer being a Si-layer 57.

As shown in Fig.4, a film forming is carried out in a vacuum container 40 by irradiating a target material 42 to be a film material with an ion beam from an ion source 43 to scatter atoms of the target material, and depositing the scattered atoms of the target material on a surface of a substrate 41 which is arranged in the container 40. The target material 42 is supported on a target material holder 48. Mo and Si as the target material 42 are provided and alternately deposited while being chosen one by one to form the multi-layered film. The substrate 41 is supported on a rotatably holder (a rotational means) 47 which rotates along an axis of symmetry( a center axis). During the film forming, the rotatable holder 47 is rotated along the center axis. As the result, the scattered target material forms a film so as to have a constant periodic length( film thickness) to the circumference direction of the substrate 41. The film forming apparatus according to the present embodiment uses a film thickness regulating plate 10 which is composed of two parts of a shape-constant regulating plate 11 and a shape-variable regulating plate 21 to control a periodic length distribution of the multi-layered film. The film thickness regulating plate 10 is arranged between the target material 42 and the substrate 41.

Next, the film thickness regulating plate 10 will be described in detail.

Fig.1 is a plane drawing showing a shape of the film thickness regulating plate used in a film forming apparatus according to the first embodiment of the present invention.

The film thickness regulating plate 10 of the present embodiment is composed by overlapping the shape-variable regulating plate 21 as shown in Fig. 2, and the shape-constant regulating plate 11 as shown in Fig.3.

Firstly, the shape-constant regulating plate 11 will be described referring to Fig.3. The shape-constant regulating plate 11 is composing of a ring shaped supporting plate 12 and a shielding plate 17 having a specified profile to the radius direction. Between the both plates, 12, 17, two openings 13 having an approximately semicircle shape are formed. The opening rate of the opening 13 to the radius direction is controlled by a circumference width of the shielding plate 17. The shape-constant regulating plate 11 is prepared with some types of shapes, which include almost of the various opening rates required to standard film forming processes. Among these types, the shape-constant regulating plate is chosen so as to have a difference from the optimum shape being within 5 mm.

Next, the shape-variable regulating plate 21 will be described. Fig.2(A) is a drawing showing a shape of a shape-variable regulating plate 21 which is another part of the film thickness regulating plate 10. The shape-variable regulating plate 21 has a peripheral supporting plate 22 constituting a frame of the opening 23 and two radial supporting plates 26 protruding to the center direction from the peripheral supporting plate 22. On the radial supporting plates 26, small shielding elements 27 and drivers ( piezoelectric devices, and so on) 25 mounted on the proximal ends of the elements 27 are arranged to align to the radius direction. The shielding element 27 mounted on each of the radial regulating plate 26 is a tang shaped element which protrudes to the width direction of the supporting plate 26 ( the circumference direction of the regulating plate 21). Each of the shielding elements is moved( projected and retrieved) by each of the drivers 25 to the circumferential direction within the plane of the opening 23. Incidentally, the shielding elements 27 are arranged on the surface and the back surface of the supporting plate 26, while the elements on the surface of the regulating plate being positioned off the other elements on the back surface thereof with a half width of the element 27( the shielding element on the back surface is shown in mark 27' of the Fig.2(B)). A portion without existing the supporting plate 26 and the shielding elements 27 inside of the peripheral supporting plate 21 is made to be the opening 23. In the supporting plates 26 in top and bottom of the figure, the direction to which the shielding elements 27 are projected and retrieved is an opposite direction( a same direction to the circumference direction).

Fig.2(B) is a drawing enlarged showing a part of the shape-variable regulating plate 21. Each of the shielding elements 27, 27' has a width of 2 mm and is machined to a hemispherical shape at the distal end. Since the shielding elements 27, 27' are arranged on the surface and the back surface of the supporting plate 26 while one on the surface of the regulating plate being positioned off the other on the back surface thereof with a half width of the element 27, the hemispherical distal ends of the shielding elements 27, 27' results to align with a distance of 1 mm in plane. On the proximal ends of the shielding elements 27, 27', the drivers 25 are mounted, which drive the shielding elements 27, 27' to be moved within the plane of the opening 23 to the transverse direction of the figure( the direction to which the opening is opened and closed) with a position precision of 0.01 mm. The driver 25 is made of a piezoelectric device or a small motor and controlled by a controller( not shown).

The film thickness regulating plate 10 is composed by overlapping the shape-variable regulating plate 21 and the shape-constant regulating plate 11, as shown in Fig.1. At the overlapping, one radial boundary ( end) of the two openings 13( 23) which are formed by overlapping both regulating plates 11, 21 makes a edge 17a having a profile to the radius direction of the shielding plate 17 of the shape-constant collecting plate 11, and another boundary thereof makes a edge represented by a envelope connecting the distal ends of the shape-variable shielding elements 27 of the shape-variable regulating plate 21.

On the film forming, firstly, based on a shape of the substrate 41 ( as shown in Fig.4) subjected to the film forming and a distribution of the approximately amount of the scattered atoms( sputtering particles) discharged from the target material 42 on the substrate 41, a shape of the film thickness regulating plate having a desirable periodic length( film thickness) distribution of the multi-layered film on the substrate 41 is determined by calculation. Next, the film thickness regulating plate 11 having a shape approximate to the determined optimum shape is chosen. Then, the film thickness regulating plate 10 which is assembled by the chosen shape-constant regulating plate 11 and the shape-variable regulating plate 21 is arranged at a predetermined position in the film forming apparatus 40. And, the shape of the shape-variable regulating plate 21 is controlled to the optimum shape predicted by the calculation. The shape of the shape-variable regulating plate 21 can be changed by moving each of the shielding elements 27 by the driver 25 controllable by the controller( not shown).

In such film thickness regulating plate 10, although one boundary of the shielded portion is shown in an uneven line connecting points on the hemispherical ends of the plural shielding elements 27 which are arranged on the radial supporting plate 26 with a distance of 1 mm, the uneven line does never affect the periodic length( film thickness) distribution. Because, while the sputtering source 43 of the film forming apparatus according to the present embodiment has an area of a diameter of at least about 10 cm so that a half shadow appears as mentioned-above( as shown in Fig.17), the above-mentioned variation in the uneven boundary having a period of 1 mm is smaller than the blur of the half shadow so as to be absorbed in the blur. On the other hand, it is a shape 29 of the boundary ( a line approximately connecting points on the hemispherical distal ends of the shielding elements 27), as shown in dotted line of Fig.2(B), that affects to the film thickness distribution on the substrate. Then, the shape-variable regulating plate 21 is so moved by driving the driver 25 that the difference in the shape 29 from the desirable shape ( position) is within 0.05 mm. Hereby, the film thickness regulating plate 10 having the desirable shape is obtained. Forming a film by using the film thickness regulating plate 10 makes it possible to have a film thickness distribution approximate to the desirable distribution.

However, it is difficult to have a desirable periodic length distribution in a single procedure, so the periodic length distribution obtained in practical may be different from a desirable periodic length distribution, in general. Therefore, it is necessary that after the evaluation of the periodic length distribution of the multi-layered film formed once, the variation amount in shape of the film thickness regulating plate is calculated based on the obtained distribution, and then the shape of the film thickness regulating plate 10 must be varied by the same way as mentioned above. At such variation, since the small shielding elements 27 of the shape-variable regulating plate 21 are moved by the drivers 25 controllable by the controller, the shape variation process of the regulating plate is finished in short time and next process can be started in short order. By repeating these processes in some times, the desirable film thickness distribution can be obtained. And, at the variation in the shape of the film thickness regulating plate, since it is not necessary to newly make again the regulating plate, the desirable periodic length distribution can be obtained in shorter time.

According to the above-mentioned embodiment of the present invention, while the shielding elements are moved in plane with a distance of 1 mm in order to vary the shape of the shape-variable regulating plate 21, the mechanism by which the shape of the shape-variable regulating plate 21 is varied is not limited by this.

Fig.6 is a plane drawing showing a shape-variable film thickness regulating plate which is a part of the film thickness regulating plate used to a film forming apparatus according to another embodiment of the present invention.

The shape-variable regulating plate of the embodiment has almost the same structure as the shape-variable regulating plate of Fig.2, while the shape of the shielding element is different. The shielding element 31 of the present embodiment is composed of rod shaped members 33, drivers 35 mounted at the proximal ends of the rod members 33 and shielding plates 37 mounted at the distal ends of the members 33. The shielding plate 37 is rotatably mounted by a pin 39 between the distal ends of the adjacent rod members 33. The drivers 35 are arranged on one surface of the radial supporting plate 26( as shown in Fig.2) with a distance of 5 mm , and can move the rod members 33 with a precision of 0.01 mm. By moving the rod member 33, an edge in the side of the opening of the shielding plate 37 is displaced to vary a boundary (contour) of the shielding element 31 of the film thickness regulating plate.

In the shape-variable regulating plate of the present embodiment, since the rod members 33 are arranged with a distance of 5 mm, the contour of the film thickness regulating plate may be modified with a distance of 5mm only. However, in general, since the film thickness regulating plate is required the shape in which the contour thereof varies in the radius direction relatively smoothly, even if it is modified with a distance of 5 mm, the difference from the desirable curve is so small. The distance between a segment connecting two points of the distal ends of the rod members 33 arranged in a distance of 5 mm, and an arc passing these two points, is less than 0.1 mm when the radius of curvature of the arc is 30 mm or more. Although the film thickness regulating plate of Fig.1 needs to move more than 100 small shielding elements, the structure according to the present embodiment makes it possible to reduce the number of the member and driver less than the half thereof without so losing the required accuracy.

According to the embodiment of the present invention, while the shape of the shape-variable regulating plate is varied by the controllable driver, the control means is not limited by this and may be the manual operation, if the required accuracy can be achieved.

Fig. 10 is a plane drawing showing a shape of the film thickness regulating plate used to a film forming apparatus according to the second embodiment of the present invention.

Fig.11 is a plane drawing showing a shape of a center regulating plate which is a part of the film thickness regulating plate of Fig.10.

Fig.12 is a plane drawing showing a shape of a peripheral regulating plate which is a part of the film thickness regulating plate of Fig.10. Fig.13 is a drawing schematically showing a principle part of a film forming apparatus according to the second embodiment of the present invention.

Fig.14 is a graph showing a variation in distribution of a film thickness due to a film forming method according to the present invention. The ordinate axis shows a film thickness( periodic length) and the abscissa axis shows a position on the substrate.

Firstly, a case that a Mo/Si multi-layered film is formed on a substrate with a desirable periodic length ( film thickness) distribution will be described referring to Fig.13. The formed multi-layered film has the same structure as that of the multi-layered reflection mirror 51, as shown in Fig.5.

A film forming is carried out in a vacuum container 80 by irradiating a target material 82 to be a film material with an ion beam from an ion source 83 to scatter atoms of the target material, and depositing the scattered atoms of the target material on a surface of a substrate 81 which is arranged in the container. The target material 82 is supported on a target material holder 88. The target material 82 is provided with Mo and Si which are alternately deposited while being chosen one by one to form the multi-layered film. The substrate 81 is a rotational symmetrical shape having no opening at the center thereof and supported on a rotatably holder (a rotational means) 87 which rotates along an axis of symmetry( a center axis). During the film forming, the substrate 81 is rotated along the center axis. As the result, a film making of the same substance as the target material is formed to have a constant periodic length( film thickness) in the circumference direction. The film thickness regulating plate 60 is arranged between the target material 82 and the substrate 81 to control the periodic length( film thickness) distribution.

Next, the film thickness regulating plate 60 will be described in detail referring to Fig.10. The film thickness regulating plate 60 is composed by assembling a center regulating plate 61( as shown in Fig.11) and a peripheral regulating plate 71( as shown in Fig.12). The center regulating plate 61 controls a film thickness distribution at the center of the substrate 81, and the peripheral regulating plate 71 controls a film thickness distribution at the periphery away from the center axis of the substrate 81.

Firstly, the center regulating plate 61 will be described referring to Fig.11. The center regulating plate 61 has a ring shaped supporting plate 62 with an opening 63. In the center region of the opening 63, a square shaped mesh part 65 is provided, which is secured by bises 68 to two supporting portions 64 extending from the supporting plate 62 to the center. The mesh part 65 controls the film thickness distribution at the center of the substrate. And, the supporting plate 62 is provided with two positioning holes 67, which are used to position the film thickness regulating plate, as mentioned below.

In the mesh part 65, openings 66 having a square shape with a side length of 1.8 mm are arranged in lattice state with a distance of 2 mm. Each of the openings 66 is arranged with a distance smaller than a half of the area( for instance, about 8 mm) of the half shadow appeared by the film thickness regulating plate on the substrate at the film forming. And, the opening rate of the mesh part 65 of the film thickness regulating plate is about 80 % and evenly distributed.

When a film forming is carried out by the film forming apparatus without using the film thickness regulating plate, the formed film thickness shows a distribution as shown in a curve 93 of the Fig. 14 (A). That is, the film thickness at the periphery of the substrate is thinner than that of the center thereof by about 15 %, and the film thickness especially at the center is thicker than that of the desirable film thickness 91. Here, mark 91 in the figure shows a desirable film thickness distribution range( the following is the same). On the other hand, when the film thickness regulating plate 61 is used, the formed film thickness shows a distribution as shown in a curve 95 of the Fig.14(B). That is, the film thickness only at the center of the substrate becomes thin compared with the periphery thereof and almost uniform, whereby it is in the desirable range of the film thickness distribution.

In the film forming apparatus( as shown in Fig. 13) according to the present embodiment, the distance between the substrate 81 and the film thickness regulating plate 60 is 20 to 30 mm, which is a suitable distance capable of preventing a danger that the film thickness regulating plate 60 may contact with the substrate 81. On the other hand, if the film thickness regulating plate 60 is too far from the substrate 81, since there is a danger that the desirable range can not be controlled with a sufficiently precision due to the half shadow blur, the distance is desirable to be about 20 mm.

In the film forming apparatus according to the present embodiment, the size of the ion source 83 is about 20 cm in the diameter and the distance between the target material 82 and the substrate 81 is 50 cm. As the result, the area of the half shadow appeared by the film thickness regulating plate 60 on the substrate 81 is about 8 mm. As mentioned above, since the openings 66 of the mesh part 65 of the center regulating plate 61 are arranged with a distance of 2 mm which is smaller than half of the area of the half shadow, a distribution along the shadow of the film thickness regulating plate ( the shadow of the mesh of the mesh part) is never formed. And, since the opening rate of the mesh part 65 of the center regulating plate 61 is about 80 %, the amount of sputtering particles reached to the substrate 81 is about 80 % of the amount of the sputtering particles reached to the mesh part 65. On the other hand, at the region( peripheral region) away from the center of the substrate, the film thickness has a distribution which the film thickness is thin as the periphery ( as shown in Fig14(B)), similar as the case that there is no film thickness regulating plate. It is thought the reason why, in the graph of the Fig.14(B), the curve 95 shown the film thickness smoothly connects between the center of the substrate, where the film thickness is thin, and the periphery thereof, where the film thickness is thick, is that the scattered particles turn into the mesh part from the opening out of the mesh part, whereby the difference in the film thickness at the boundary becomes so smooth. And, another reason is that since the shape of the mesh is a square and not a circle with a center of the axis of symmetry of the substrate, the mesh part secured relative to the surface of the rotating substrate unevenly shields the particles in the radial direction at the periphery of the mesh part.

Next, the peripheral regulating plate 71 will be described referring to Fig.12.

The peripheral regulating plate 71 has a ring shaped supporting plate 72 having an opening 73. In the opening 73, two shielding plates 74 are oppositely ( toward the center) projected from a supporting plate 72. The distal ends of the shielding plates 74 do not reach the center of the opening 73. The shielding plate 74 is so composed to have a specified profile to the radial direction to be controlled the opening rate to the radial direction( the opening rate to the circumference direction).

And, the supporting plate 72 is provided with a positioning hole 77, which is used for positioning the film thickness regulating plate, as mentioned below. Although the peripheral regulating plate 71 having such shape can not regulate the film thickness on the center of the substrate, according to the present embodiment, the film thickness on the center of the substrate is controlled to the desirable range of the film thickness distribution by the center regulating plate 61 so that there is no necessity of regulating the film thickness on the center by using the peripheral regulating plate 71. And, at the region away from the center, the longer the distance from the center to the radial direction is (as the outside), the smaller the influence of the half shadow is, so that it does not need to regulate against the influence of the half shadow. So, even if using the peripheral regulating plate having such shape, the film thickness distribution generated in general can be regulated.

The film thickness regulating plate 60 is composed by overlapping the center regulating plate 61 and the peripheral regulating plate 71, as shown in Fig.10. Then, both regulating plate 61 and 71 are so overlapped that the straight portion of the shielding part 74 of the peripheral regulating plate 71 coincides the supporting portion 64 of the center regulating plate 61. The thickness distribution of the film formed by using the film thickness regulating plate 60 is shown in a curve 97 of Fig.14(C). The curve 97 shows that the film thickness distribution having a desirable film thickness and within the desirable range 91 all over the substrate can be achieved.

The opening rate of the mesh part 65 of the center regulating plate 61 according to the present embodiment is about 80 %. By the way, the film forming apparatus having such structure originally has a characteristic that the film thickness is so distributed to be thick at the center and to be thin at the periphery. In general, it is founded that the film thickness at the periphery is thinner than that at the center by 15 %, on the basis of the degree, the opening rate of the mesh part 65 is chosen. Since by using the center regulating plate 61, the film thickness is distributed to be thin at the center only to become the desirable film thickness as shown in Fig.14(B), it is enough to control the film thickness distribution so as to be thin by most 20 % at the center and by 5 % at the periphery by using the peripheral regulating plate 71. However, if the opening rate of the mesh part 65 of the center regulating plate 61 is 50 % for instance, the range in the film thickness to be controlled by the peripheral regulating plate 71 becomes large and it is necessary to regulate by 35 % at the most peripheral portion. Because, the larger the opening rate of the mesh part 65 is, the larger the rate of the particles which are shielded by the film thickness regulating plate among the scattered particles( the sputtering particles) is, so that the film forming rate on the substrate is reduced.

In order to obtain the desirable film thickness distribution, it is desirable that the opening rate of the mesh part 65 of the center regulating plate 61 is heighten as much as possible to form the film in shorter time. According to the present embodiment, by making the opening rate of the mesh part 65 of the center regulating plate 61 to be 80 %, it is achieved that a large opening rate can be obtain all over the substrate to be able to form the film in the shorter time.

As mentioned above, each of the supporting portions 62 of the center regulating plate 61 and the supporting portions 72 of the peripheral regulating plate 71 has the positioning holes 67 and 77 respectively, through which a parallel pin is passed to position both regulating plate 61 and 71 relative to the substrate with a precision of under 0.1 mm. If the both regulating plate 61 and 71 are shifted relative to the substrate, the film thickness distribution may be changed with the result that a desirable film thickness distribution is not obtained. However, the position of the film thickness regulating plate can be determined with well precision to be able to control the film thickness on the substrate.

According to the present embodiment, the mesh part 65 of the center regulating plate 61 and the opening 66 formed on the mesh part 65 is square in shape. While, the shape of the opening 66 is not limited by square and may be irregular shape if having a sufficiently opening rate( for instance over 70 %) and maintaining the strength of the regulating plate. Or, the mesh part 65 may be a mesh which is formed by knitting the fine linear member. And, in order to form a film on considering the film thickness distribution at the center of the substrate also, on the mesh part 65 of the center regulating plate 61, a plurality of openings which changes its opening rate in the radial direction may be arranged. And, the shape of the mesh part 65 of the center regulating plate 61 is not limited by square.

According to the present embodiment, while the thickness of the film thickness regulating plate 60 is 0.5 mm, the thickness is not limited by this and may be about 0.1 to 1.0 mm. However, in order to prevent occurring a problem in the control precision of the distribution by a deformation of the regulating plate due to the stress of the film at the film forming, it is preferable that in the case that the thickness of the film regulating plate is less than 0.5 mm, it has a structure capable of suppressing the deformation due to the stress of the formed multi-layered film by using a supporting member having a thickness of thicker than 0.5 mm.

According to the present embodiment, while the film thickness regulating plate 60 is constituted by assembling the center regulating plate 61 and the peripheral regulating plate 71, there is no necessity of always being separated into the center regulating plate 61 and the peripheral regulating plate 71 and it may be constituted by one film thickness regulating plate. And, in the case that it is composed by assembling the center regulating plate 61 and the peripheral regulating plate 71, it is not necessary to arrange the both regulating plates away from the substrate with almost the same distance.

And, the apparatus and method which a film forming is carried out while controlling the distribution of the periodic length of the multi-layered film is described mainly, the film formed by using the present invention is not limited to the multi-layered film and may be a single-layered film, the present invention will be applied to all of the film forming required to control the film thickness.

As mentioned above, while the film forming method according to the embodiment of the present invention has been described, the present invention is not limited by this and may add various changes.

INDUSTRIAL APPLICABILITY

As previously described, according to the present invention, a film forming method and apparatus are provided, in which the distribution of the film thickness can be easily controlled at the center of the substrate and a desirable film thickness distribution can be obtained in the shorter time. And, by using such film forming method and apparatus, a multi-layered film mirror having a desirable film thickness distribution can be obtained in the shorter time.

**Claims**

1.   A film forming method comprising:

rotating a rotational symmetrical substrate on which a film is formed along the rotational symmetry axis in a sufficiently vacuum container;
heating or irradiating ion beam to a target material in the container to scatter atoms of the target material; and
depositing the scattered atoms on the substrate,
wherein a film thickness regulating plate which shields part of the scattered atoms is arranged near the substrate,
said regulating plate being variable in shape.

2.   A manufacturing method for a multi-layered film reflection mirror, wherein a multi-layered structure that at least two types of substance having a different reflective index are deposited alternatively is formed on a substrate by means of the film forming method according to claim 1.

3.   A film forming apparatus,

which rotates a rotational symmetrical substrate on which a film is formed along the rotational symmetry axis in a sufficiently vacuum container;
heats or irradiates ion beam a target material in the container to scatter atoms of the target material; and
deposits the scattered atoms on the substrate,
wherein a film thickness regulating plate which shields part of the scattered atoms is arranged near the substrate,
said regulating plate being variable in shape.

4.   A film forming apparatus comprising:

a container capable of being vacuumed;
means for rotating a substrate on which a film is formed, arranged in said container;
a holder for supporting a target material, arranged in the container;
means for scattering atoms of the target material; and
a film thickness regulating plate which shields part of the scattered atoms arranged between the substrate rotating means and the target material holder,

wherein said film thickness regulating plate is variable in shape.

5.   The film forming apparatus according to claim 3 or 4,
wherein the film thickness regulating plate is composed of a shape-constant regulating plate and a shape-variable regulating plate.

6.   The film forming apparatus according to claim 5,
wherein the shape-variable regulating plate is provided with shielding elements and drivers, and

the driver moves the shielding element with a position precision of at least 0.01 mm.

7.   A film forming method comprising:

rotating a rotational symmetrical substrate on which a film is formed along the rotational symmetry axis in a sufficiently vacuum container;
heating or irradiating ion beam to a target material in the container to scatter atoms of the target material; and
depositing the scattered atoms on the substrate,
wherein a film thickness regulating plate which shields part of the scattered atoms is arranged near the substrate,
said film thickness regulating plate having:
a plurality of openings arranged scatteringly with a distance under half of an area of a half shadow of said film thickness regulating plate, appeared on the substrate by a particle beam made of the scattered atoms of the target material, near the part correspondent to the rotational axis of symmetry of the substrate; and
an opening of which the opening rate is controlled by relatively small number of shielding plates arranged partially in the radial direction, near the part correspondent to the periphery of the substrate.

8.   A manufacturing method for a multi-layered film reflection mirror, wherein a multi-layered film having a structure that at least two types of substance having a different reflective index are deposited alternatively is formed on a substrate by using the film forming method according to claim 7.

9. A film forming apparatus, which rotates a rotational symmetrical substrate on which a film is formed along the rotational symmetry axis in a sufficiently vacuum container;

heats or irradiates ion beam to a target material in the container to scatter atoms of the target material; and
deposits the scattered atoms on the substrate, wherein a film thickness regulating plate which shields part of the scattered atoms is arranged near the substrate,
said film thickness regulating plate having:
a plurality of openings arranged scatteringly with a distance under half of an area of a half shadow of said film thickness regulating plate, the half shadow appeared on the substrate by a particle beam made of the scattered atoms of the target material, near the part correspondent to the rotational symmetrical axis of the substrate; and
an opening of which the opening rate is controlled by relatively small number of shielding plates arranged partially in the radial direction, near the part correspondent to the periphery of the substrate.

10. A film forming apparatus comprising:

a container capable of being vacuumed,
means for rotating a substrate on which a film is formed, arranged in said container,
a holder for supporting a target material, arranged in the container,
means for scattering an atom of the target material; and
a film thickness regulating plate which shields part of scattered atoms arranged between the substrate rotating means and the target material holder,
wherein said film thickness regulating plate has a plurality of openings arranged scatteringly with a distance under half of an area of a half shadow of said film thickness regulating plate, the half shadow appeared on the substrate by a particle beam made of the scattered atoms of the target material, near the part correspondent to the rotational axis of symmetry of the substrate; and
an opening of which the opening rate is controlled by relatively small number of shielding plates arranged partially in the radial direction, near the part correspondent to the periphery of the substrate.

11. The film forming apparatus according to claim 9 or 10,
wherein the openings are so arranged that the opening rate thereof is uniform to the radial direction of the film thickness regulating plate.

12. The film forming apparatus according to claim 9 or 10,
wherein the openings are so arranged that the opening rate thereof is intentionally controlled to the radial direction of the film thickness regulating plate.

13. The film forming apparatus according to one of claims 9 to 12, wherein the film thickness regulating plate is composed of

a center regulating plate having scatteringly arranged openings, arranged near the part correspondent to the rotational axis of symmetry of the substrate, and
a peripheral regulating plate having an opening controlled the opening rate to the radial direction, arranged in the periphery of the substrate

14. The film forming apparatus according to one of claims 9 to 12, wherein the thickness of the film thickness regulating plate is over 0.5 mm.

15. The film forming apparatus according to one of claims 9 to 13, wherein the film thickness regulating plate is supported by a supporting frame having a thickness of over 0.5 mm.

16. The film forming apparatus according to one of claims 9 to 15, wherein the film thickness regulating plate has a structure capable of being positioned to the substrate with a precision of under 0.1 mm.

# FIG. 1

## FIG. 2A

## FIG. 2B

*FIG. 3*

# FIG. 4

# FIG. 5

## FIG. 6

# FIG. 7

*FIG. 8*

## FIG. 9

film thickness (periodic length)

111

do

113

dm

115

0    distance to radial direction

# FIG. 10

# FIG. 11

*FIG. 12*

## FIG. 13

*FIG. 14A*

*FIG. 14B*

*FIG. 14C*

distance to radial direction

# FIG. 15A

# FIG. 15B

0.03～0.07mm

123

0.1mm

0.1mm

EP 1 400 608 A1

# FIG. 16A

# FIG. 16B

# FIG. 17

29

# FIG. 18

## INTERNATIONAL SEARCH REPORT

| International application No. |
|---|
| PCT/JP02/01713 |

**A. CLASSIFICATION OF SUBJECT MATTER**
Int.Cl$^7$ C23C14/34, 14/46, G02B5/08, 5/28

According to International Patent Classification (IPC) or to both national classification and IPC

**B. FIELDS SEARCHED**

Minimum documentation searched (classification system followed by classification symbols)
Int.Cl$^7$ C23C14/00-14/58, G02B5/08, 5/28

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)
WPI/L[C23C-014/34 and G02B-005/08]

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 61-183464 A (NEC Corp.),<br>16 August, 1986 (16.08.86),<br>Claims; problems that the invention is to solve;<br>effects of the invention; Fig. 2; full description<br>(Family: none) | 1-6<br>7-16 |
| Y<br>A | JP 61-17549 Y2 (Sony Corp.),<br>29 May, 1986 (29.05.86),<br>Claims; page 2, column 4, line 20 to page 3, column<br>6, line 2; Figs. 1 to 3; full description<br>(Family: none) | 1-6<br>7-16 |
| Y<br>A | JP 10-26698 A (Nikon Corp.),<br>27 January, 1998 (27.01.98),<br>Claims; Par. Nos. [0001], [0029] to [0031], [0035],<br>[0063]; Fig. 5; full description (Family: none) | 1-6<br>7-16 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>21 May, 2002 (21.05.02) | Date of mailing of the international search report<br>11 June, 2002 (11.06.02) |
|---|---|
| Name and mailing address of the ISA/<br>Japanese Patent Office | Authorized officer |
| Facsimile No. | Telephone No. |

Form PCT/ISA/210 (second sheet) (July 1998)